# EUROPEAN PATENT APPLICATION

(11) **EP 0 866 502 A2**
(43) Date of publication of application: **23.09.1998**
(21) Application number: 98302134.6
(22) Date of filing: 23.03.1998
(51) Int. Cl.: H01L 27/148, H04N 3/15

(54) **Architecture for a CCD-imager with multiple readout registers**

(30) Priority: 21.03.1997 US 42327 P; 11.06.1997 US 49978 P; 23.09.1997 US 935634
(71) Applicant: DALSA INC., Waterloo Ontario N2V 2E9 (CA)
(72) Inventor: Kiik, Martin J., East Waterloo, Ontario N2J 1B9 (CA); Fox, Eric C., Waterloo, Ontario N2T 1G2 (CA); Flood, Colin J., North Kitchener, Ontario N3H 3A9 (CA); Ingram, Simon G., Waterloo, Ontario N2T 2AV (CA); Kamasz, Stacy R., Kitchener, Ontario N2C 1J4 (CA)
(74) Representative: Evens, Paul Jonathan

(57) **Abstract**

A charge coupled device (100) includes an imaging section (102) and a readout section (104). The imaging section (102) defines a column direction and includes a plurality of imaging subsections. The readout section (104) includes a first output node structure (116) and a plurality of readout subsections. A first readout subsection (106) is coupled to a respective first imaging subsection. A second readout subsection is coupled to a respective second imaging subsection. The first readout subsection (106) includes a first 1 plurality of intermediate registers (110) and a first horizontal register segment (112). A first intermediate register of the first plurality of intermediate registers (110) defines a first intermediate direction, the first intermediate direction being non-parallel to the column direction. The second readout subsection includes a second plurality of intermediate registers and a second horizontal register segment, a layout area being defined between the first and second readout subsections. The first output node structure (116) is coupled to the first horizontal register segment (112) and disposed within the layout area.

## Description

### BACKGROUND OF THE INVENTION

The priority benefit of application 60/042,327 filed March 21, 1997 and application 60/049,978 filed June 11, 1997 is hearby claimed.

### Field of the Invention

The invention relates generally to charge coupled device image sensors and specifically to structures that provide for optimized output node structures and necessary isolation pixels in multi-tapped horizontal CCD readout registers.

### Description Of Related Art

Charge coupled devices (hereinafter CCDs) are widely used in video imaging and recording applications. For example, the architecture of a CCD video sensor may follow the form dictated by the National Television Standards Committee (NTSC) for video broadcast standards. Such CCD video sensor designs need at least 488 TV lines vertically, 500 to 800 pixels per TV line, have an optical format of 4/3 aspect ratio, and generate field interlaced video at a frame rate of 30 Hz. CCD architectures which achieved the goals of the video format imaging requirements generally fall into two categories: Interline Transfer (ILT) or Frame Transfer (FT) image sensors.

An alternative application of a CCD sensor is industrial inspection or vision equipment. The architecture of a CCD video sensor for this application may be optimized for maximum pixel resolution, or to maximize image frame rate, or both. Often inspection cameras used to inspect moving objects (e.g., on a continuous conveyor belt or rolled goods such as rolls of cloth) employ a line scan CCD sensor where a linear CCD sensor is oriented in a direction perpendicular to the direction of movement of the object being imaged. Advanced linear CCD sensor often employ an time delay and integrate technology and are referred to as TDI CCD sensors.

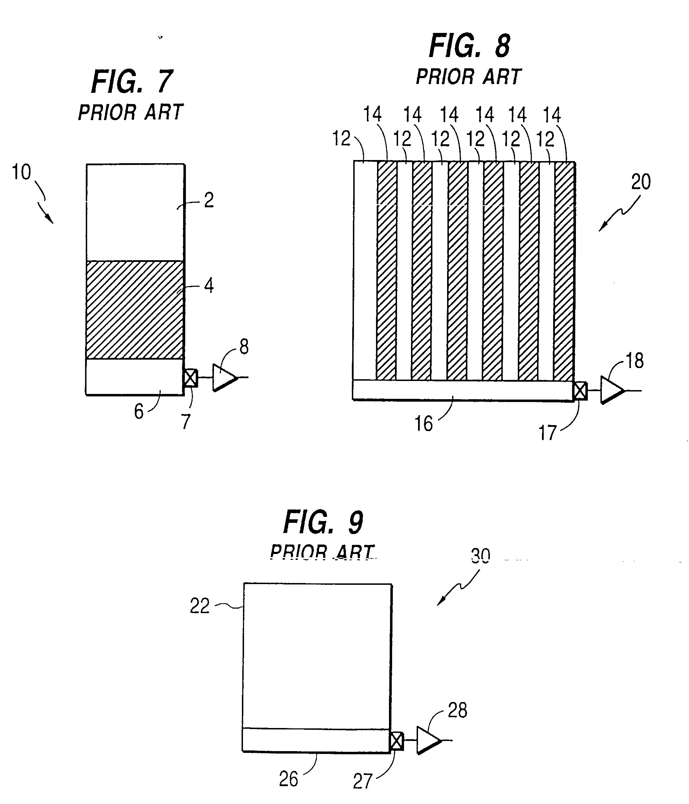

In FIG. 7, known frame transfer sensor 10 includes imaging section 2 coupled to storage section 4. Frame transfer sensors rely on the quick transfer of image field data from an array of photo-sensitive photo-sites in imaging section 2 where photo-charge is integrated (i.e., the imaging section) to an optically opaque analog storage array (i.e., storage section 4), and the subsequent parallel to serial transfer of the video data through horizontal CCD readout shift register 6 (HCCD shift register) through output node structure 7, through buffer 8 to a camera circuit. An optically opaque storage array is a storage array that is covered by an optically opaque material such as an aluminum film so that the storage array is not photo-sensitive. The rapid vertical transfer ofthe image data from integration of the first video field is vital since the optical input onto the imaging section of the CCD sensor is continuous (not strobed or modulated during transfer).

In FIG. 8, known interline transfer CCD image sensor 20 (i.e., an ILT CCD sensor) includes imaging section 12 in a plurality of columns of photo-sites, each column disposed adjacent to an optically opaque interline transfer register 14 (e.g., covered with aluminum to render the transfer register insensitive to optical input). An ILT CCD sensor generally has no optically opaque storage section as does the frame transfer sensor. In an ILT CCD sensor, optical input is integrated in photo-sites 12 and then transferred to interline transfer registers 14. Then, during the integration of the next field of data, the field of image data in interline transfer registers 14 are parallel to serial transferred through horizontal CCD shift register 16 (HCCD shift register) through output node structure 17, through buffer 18 to a camera circuit.

In FIG. 9, known time delay and integrate (TDI) linear array sensor 30 includes imaging section 22 as in a frame transfer sensor, but the imaging section is generally coupled directly to horizontal CCD readout shift register 26, and from there through output node structure 27, through buffer 28 to a camera circuit. Imaging section 22 includes a plurality of columns, each column including a plurality of photo-sites. In operation, a camera lens focuses the image on the TDI CCD sensor. The image, that is the optical input to the TDI CCD sensor, is moving (e.g., on a conveyor belt). Thus, an image conjugate focused on the sensor appears to be moving. A portion of the image first appears on one pixel of the TDI CCD sensor, and then appears on another pixel of the sensor. The camera and sensor are arranged so that a portion of the moving image moves in a direction from the top of a column of photo-sites to the bottom of the column. The TDI CCD sensor is clocked to transfer charge down the columns of photo-sites at a rate equal to the rate that the portion of the image moves down the column. Charge generated at a first photo-site is transferred to the next photo-site at the same time that the image portion that generated the charge at the first photo-site moves to the next photo-site. In this way photo-charge is accumulated at the photo-site under the image portion as the image portion moves down the column. Thus the name, time delay and integrate (TDI).

Two-dimensional imaging arrays (e.g., in frame transfer sensors and in interline transfer sensors) generally take a snap shot of an image. The whole photo-active array of pixels integrates photo-charge for a period of time. At the end of the integration time, the information is transferred from the sensor to an external circuit element using a parallel to serial transfer scheme. Each horizontal line of pixel data is transferred into a horizontal CCD readout shift register. The line of data is then transferred serially through an output node structure at the end of the register and then through a buffer amplifier. Generally, the data rate at which signal charge can be transferred is limited to a rate that is less than the bandwidth of the output structure and buffer amplifier.

Similarly, in a TDI CCD sensor, the last pixel in each integrating column of photo-sites (i.e., the last horizontal line) is transferred into a horizontal CCD readout shift register. The line of data is then transferred serially through an output node structure at the end of the register and then through a buffer amplifier. Generally the data rate at which signal charge can be transferred is limited by the bandwidth of the output structure and buffer amplifier.

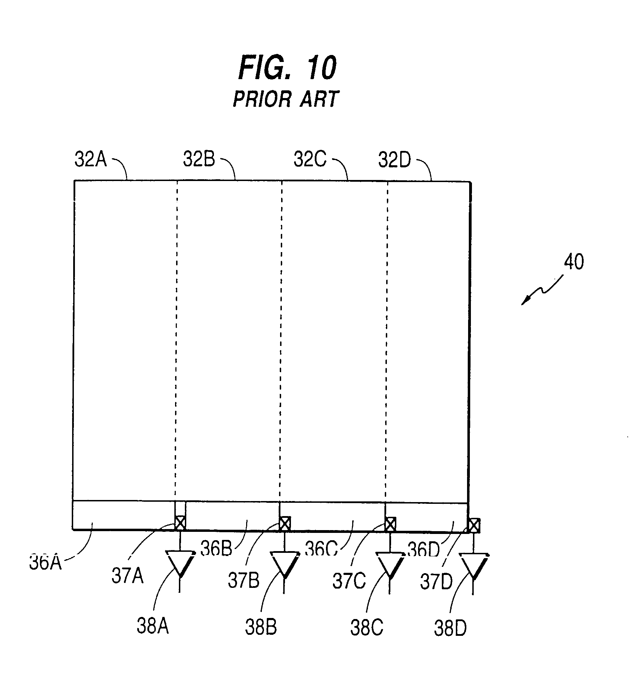

In applications where the data rate must be in excess of the buffer bandwidth, the horizontal CCD readout shift register must be partitioned into sub-registers. Each sub-register or register segment will then transfer signal charge to its own separate output node structure and buffer amplifier which operates at the bandwidth limit of the output structure and buffer. The data from several buffers is then multiplexed together to reconstruct the image at a higher data rate (i.e., the single buffer data rate multiplied by the number of output structures or taps). This register architecture is known as a multi-tapped horizontal readout register (FIG. 10).

Tapped register designs require placement of an output node structure (37A, 37B, 37C and 37D of FIG. 10) within an extent equal to the horizontal pitch (i.e., the pixel column spacing) of the register. For high density CCD sensor designs where the pitch is small in view of the minimum dimensions permitted by the design rules for the state of the processing technology used to make the CCD, it is difficult to position an output node structure within the register pitch such that the output node structure will have high performance (high conversion efficiency and low readout noise) while not sacrificing the performance of the horizontal register. See U.S. Patent No. 5,608,242 entitled Variable Width CCD Register With Uniform Pitch and Charge Storage Capacity, incorporated herein by reference.

In order to increase the data rate from sensors, tapped outputs in the horizontal readout section are commonly employed to allow different sections of the horizontal CCD to be read out simultaneously. Because of the space required for the output node structure, non-uniformities in the pixel pitch usually occur wherever an output tap is included. Furthermore, additional isolation pixels in the horizontal CCD are often desired to limit response non-uniformity in the first valid data pixel read out in each tapped section (commonly known as first pixel droop).

There is a desire to eliminate first pixel droop in these sensors while maintaining uniform pixel pitch. There is also a desire to provide additional flexibility in the design layout by the addition of a significant amount of layout area in the vicinity of each output node structure.

In accordance with the present invention, there is provided a charge coupled device that includes an imaging section and a readout section. The imaging section defines a column direction and includes a plurality of imaging subsections. The readout section includes a first output node structure and a plurality of readout subsections. A first readout subsection is coupled to a respective first imaging subsection. A second readout subsection is coupled to a respective second imaging subsection. The first readout subsection includes a first plurality of intermediate registers and a first horizontal register segment. A first intermediate register of the first plurality of intermediate registers defines a first intermediate direction, the first intermediate direction being non-parallel to the column direction. The second readout subsection includes a second plurality of intermediate registers and a second horizontal register segment, a layout area being defined between the first and second readout subsections. The first output node structure is coupled to the first horizontal register segment and disposed within the layout area.

### BRIEF DESCRIPTION OF DRAWINGS

Embodiments of the invention will now be described by way of example with reference to the accompanying figures in which:
FIG. 1 is a layout diagram of a first embodiment of the present invention;
FIG. 2 is a section view through a horizontal register, an isolation register and an output node structure of the first embodiment;
FIG. 3 is a layout diagram of intermediate registers of the first embodiment;
FIG. 4 is a representative single register element ofthe first embodiment;
FIG. 5 is a layout diagram of a second embodiment of the present invention;
FIG. 6 is a layout diagram of intermediate registers ofthe second embodiment;
FIG. 7 is a layout diagram of a known frame transfer sensor;
FIG. 8 is a layout diagram of a known interline transfer sensor;
FIG. 9 is a layout diagram of a known time delay and integrate linear sensor; and
FIG. 10 is a layout diagram depicting a multi-tapped horizontal readout register.

### DETAILED DESCRIPTION OF PREFERRED EMBODIMENTS

Preferred embodiments of this invention include the incorporation of a fan-like architecture (i,e., either flared, "skirted" or tapered as described herein) in the storage region of the sensor (for frame transfer sensors) or isolation region of the sensor (for interline transfer and TDI sensors). With such an architecture, a large amount of space is made available in the vicinity of each output tap, leading to the possibility of inclusion of an increased number of isolation pixels at each output tap between the horizontal readout register segment and the output node structure. Because of the large number of vertical pixels over which a fan architecture can be employed (i.e., the entire storage or isolation region), the number of isolation pixels that can be incorporated at each tap of the HCCD can be considerable even if fan angles are minimized.

This technique provides advantages that include ease of layout, improved pixel uniformity, and increased flexibility in node architecture design.

Incorporation of a fanned architecture into a frame transfer area array is simple, due to the presence of a large storage area. Changes to the operation of the device are limited to a slight increase in capacitance of the storage region clock phases, and timing changes due to the addition of isolation pixels. In TDI sensors, addition of a small fan isolation region with lightshield is also required, in order to incorporate large numbers of isolation pixels at each tap while maintaining a small fan angle.

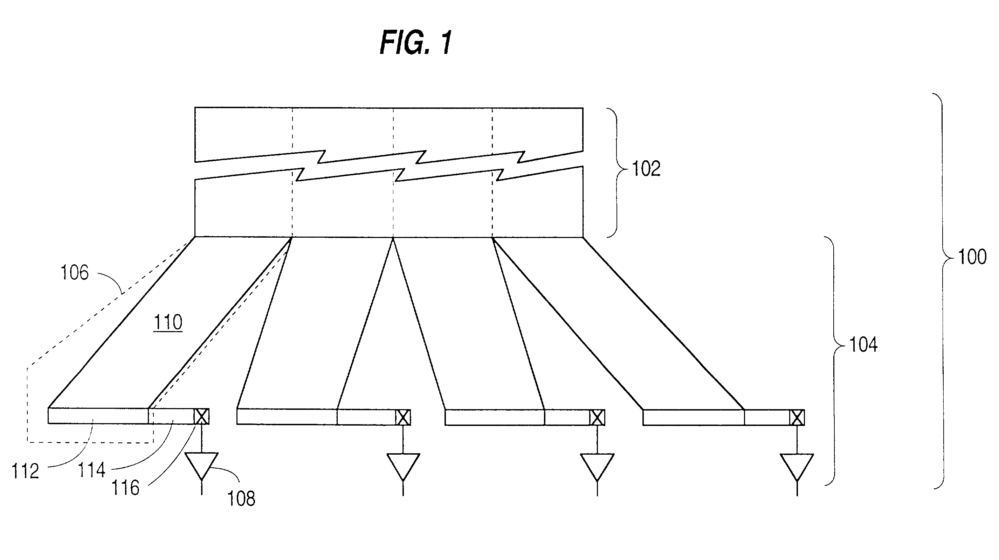

In FIG. 1, sensor 100 includes imaging section 102 and readout section 104. Imaging section 102 may be in the form of an interline transfer imaging section, frame transfer imaging section or TDI imaging section. Imaging section 102 includes a plurality of imaging subsections. Readout section 104 includes a plurality of readout subsections. First readout subsection 106 includes first plurality of intermediate registers 110 coupled between a first imaging subsection and first horizontal segment register 112. Readout section 104 further includes first output node structure 116 coupled to first horizontal segment register 112. Readout section 104 may also include first isolation register 114 coupled between first horizontal segment register 112 and first output node structure 116. An output signal from first output node structure 116 is provided to first buffer amplifier 108. Typically, buffer amplifier 108 includes from one to five MOS transistors arranged in a source follower configuration.

In a frame transfer sensor, intermediate registers 110 may advantageously be comprised of the storage array registers disposed beneath an opaque optical shield. In interline transfer sensors and TDI sensors, intermediate registers 110 may advantageously be comprised of isolation registers disposed beneath an opaque optical shield and coupled between the imaging section 102 and horizontal shift registers 112.

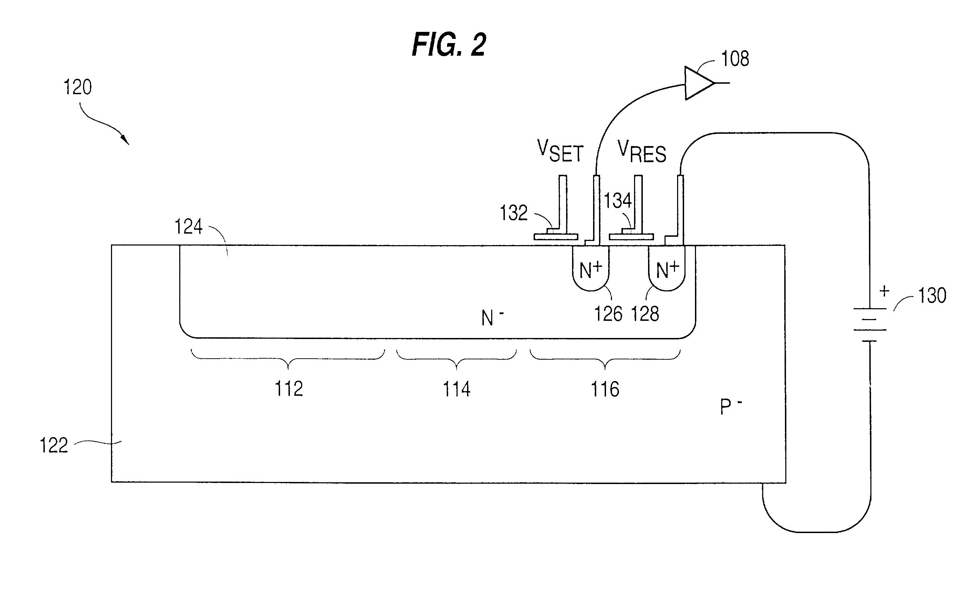

In FIG. 2, section 120 taken through horizontal readout register 112, isolation register 114 and output node structure 116 includes an N⁻ channel formed in a P⁻ type semiconductor wafer (or an N⁻ channel formed in a P⁻ type well on an N type semiconductor wafer). Buried channel 124 is formed in doped semiconductor wafer 122. Horizontal readout register segment 112 and isolation register 114 are formed within the buried channel based on clocking gate electrodes (not shown) disposed above and insulated from the buried channel. Output node structure 116 includes output node diffusion 126 coupled to output buffer 108, and includes drain diffusion 128 coupled to DC power source 130. Output node diffusion 126 is coupled to isolation register 114 through a set gate formed by set gate electrode 132 disposed over buried channel 124 and supplied with signal V_{SET}. Output node diffusion 126 is coupled to drain diffusion 128 through a reset gate formed beneath reset gate electrode 134 supplied with signal V_{RES}. Preferably, horizontal readout register 112, isolation register 114 and output node structure 116 are collinear. Preferably, all horizontal readout registers 112, isolation registers 114 and output node structures 116 in all readout subsections are collinear and perpendicular a column direction defined by the imaging section.

Isolation register 114 includes one or more pixels, preferably, at least two. A transfer electrode is used to transfer signal charge from the last register element of intermediate registers 110 into horizontal readout register segment 112. Horizontal register clocking electrodes are used to cause the fast transfer of signal charge through horizontal readout register segment 112 into isolation register 114 and from there into output node structure 116. Clock driving circuits supplying voltage to the horizontal register clocking electrodes sometimes require a few clock cycles to stabilize voltage levels. Since clock pulse feed through may appear on the video signal, variances in the first few clock pulses can produce differences in the output waveform. Therefore, isolation register 114 is advantageously interposed between the last element of horizontal readout register segment 112 and output node structure 116. Preferably, isolation register 114 includes one or more register elements. Initial data from isolation register 114 is passed out through buffer 108 before image data is processed.

A width of isolation register 114 preferably tapers from a width of horizontal readout register segment 112 to a width ofthe set gate defined by set gate electrode 132 (i.e., the buried channel width). The width of horizontal readout register segment 112 is preferably defined so that an area of each element of the register is substantially equal to an area of each register element of each intermediate register 110 to have equal charge carrying capacity as discussed in more detail herein. On the other hand, output node diffusion 126 is preferably small so as to be characterized by a minimum capacitance. This maximizes the output node structure sensitivity (i.e., volts output per electron of charge input). Often, the width of horizontal readout register segment 112 is wider than node diffusion 126 and the set gate defined by set gate electrode 132. Isolation register 114 is coupled between horizontal readout register segment 112 and the set gate. Isolation register 114 is advantageously tapered so as to match the width of horizontal segment readout register 112 to the width of the set gate. This taper may be a stepped taper arrangement or a continuous taper.

An area of each register element in the tapered isolation register 114 is substantially equal to an area of each register element of horizontal readout register segment 112 to have equal charge carrying capacity as discussed in more detail herein. This necessarily requires that the longitudinal extent of a register element (i.e., called pitch) becomes longer as the width becomes less.

Output node structure 116 may have pockets, traps or small wells in which signal charge can become trapped as it is transferred from register 112 through register 114 to node structure 116 to buffer 108. Some such pockets can contribute to the "first pixel droop" phenomenon. A common cause of such pockets is poor matching between register 112 and node structure 116. Poor matching, in turn is caused by a need to have a small readout node structure 116 compared to a size of register elements in register 112. It is advantageous to couple horizontal readout register segment 112 though matching isolation register 114 to output node structure 116 to minimize these pockets. The data initially contained in isolation register 114 is simply discarded.

First pixel droop may also be caused by non-uniformities in the DC offset levels of the CR shift register clock signals (i.e., clock signals to horizontal readout register segment 112) when they are stopped and restarted. The horizontal shift register will be stopped as charge is transferred from the vertical to horizontal shift registers; this will cause the clocks (and their associated signal and ground bounce feedthroughs) to shift their DC offset levels. When the clocks restart, there will be a droop in the first few pixels read out as the DC level restabilizes, leading to first pixel droop. Isolation pixels in isolation register 114 may be added in the area made available when employing the present fan-like or skirt architecture to avoid first pixel droop problems.

Furthermore, light leakage (especially in the red spectrum) from an edge of the light shield to the last pixel before the node structure may lead to additional electrons in the last horizontal shift register elements. Typically, a separate light shield is disposed over buffer 108 giving rise to this edge effect. That is, the end of the light shield may not be sufficiently far away from the last pixel before the output node. Again, isolation pixels may be inserted between the node and the horizontal register segment to avoid first pixel droop problems.

Another cause of first pixel droop is transient amplifier offsets. Transient output amplifier offsets may occur during the first few clock transitions after transfer from the vertical shift registers to horizontal shift register. This can lead to first pixel droop or first pixel overshoot. Once again, additional isolation pixels avoids first pixel droop problems.

It should be noted that an attempt to list all the possible causes of first pixel droop is beyond the scope of this patent. However, other causes of first pixel droop are equivalent to those discussed herein. The present architecture permits the inclusion of isolation register 114 so that first pixel droop problems from all causes may be avoided.

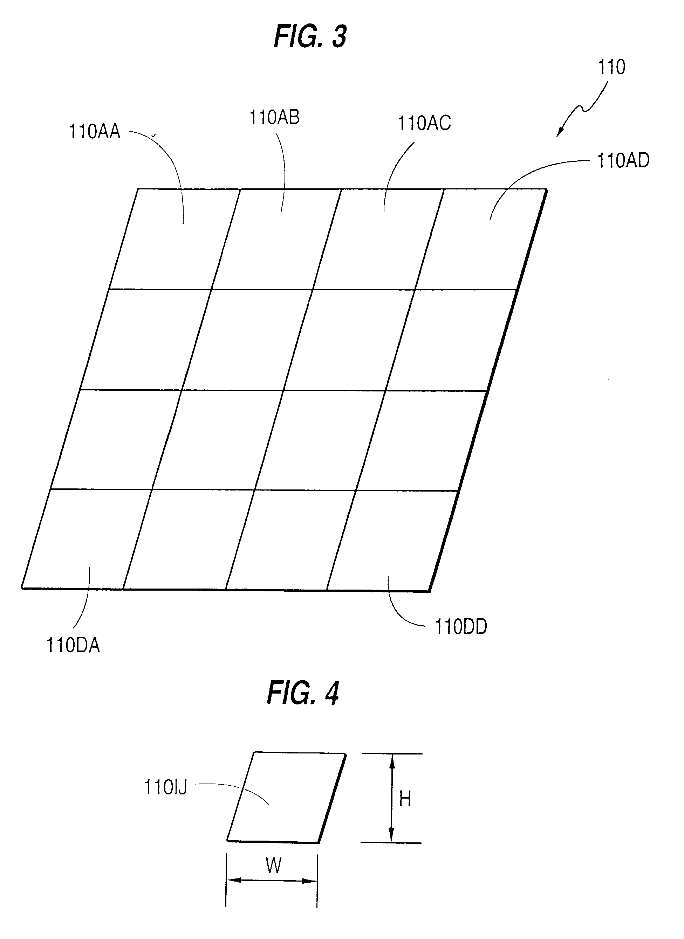

In FIG. 3, intermediate registers 110 include a first register having a plurality of register elements labeled 110AA through 110DA. A second register begins at register element 110AB, a third register begins at register element 110AC, and a fourth register begins at register element 110AD and continues down the array to register element 110DD. FIG. 3 depicts four registers, each register having four register elements. It will be appreciated that these dimensions are merely illustrative. Practical and useful devices are formed from larger arrays. For example, a large TDI sensor may include 2048 pixels wide by 96 rows (to integrate 96 pixels of data) and include 64 taps (i.e., 64 sets of isolation registers 114 and output node structures 116). In such a TDI sensor, each horizontal segment readout register 112 would have 32 pixels. The size (in pixels) of isolation register is preferably limited to not more than 10% of the size (in pixels) of the horizontal segment readout register size since the isolation pixels do not contain valid data and yet require time to read out. Thus, when the horizontal segment readout register has 32 pixels, the isolation register may have 4 pixels. In other applications, frame transfer or interline transfer sensors may advantageously have large arrays of photo-sites, for example, 256 by 256 or 512 by 512. Depending on the preferred design integration time and time available to transfer data, from 2 to 128 taps may be used in the readout section. For example, a 512 by 512 pixel array may use 4 taps so that each tap will transfer 65,536 pixels of data (i.e., 512 rows times 512 columns divided by 4 taps) during an integration time.

Each element of array 110 (FIG. 3 )takes on the shape of a non-rectangular (and non-square) parallelogram (FIG. 4). Areas of the elements of the array are substantially equal or nearly equal in area (i.e., size) and shape so as to have equal charge capacity.

The non-rectangular parallelogram nature of the register elements provide first plurality of intermediate registers 110 (FIG. 1) as having a perimeter that is itself a non-rectangular parallelogram. In operation, charges are transferred down columns of imaging subsections in imaging section 102 in a column direction. Upon being transferred to first plurality of intermediate registers 110, charges are transferred down the intermediate registers in a first intermediate direction, the first intermediate direction being non-parallel to the column direction.

In FIG. 1, sensor 100 is depicted with only four readouts subsections for illustrative purposes. It will be appreciated that practical and useful sensors may be formed of many more readout subsections. In FIG. I, half of the readout subsections are angled to the left, and the other half are angled to the right. Although FIG. 1 depicts symmetrically angled intermediate registers, asymmetrically angled registers are contemplated as well. Furthermore, ofthe half of the readout subsections that are angled to the left, the more central subsection is angled slightly, and the more extreme (i.e., on the end) subsection is angled more sharply. As depicted in FIG. 1, this arrangement provides wedge like layout areas between readout subsections, each readout subsection including the plurality of intermediate registers 110 and the horizontal readout segment registers 112. In this wedge like layout area, advantageously disposed is isolation register 114 (comprised of one or more isolation register elements) and output node structure 116. Output buffer amplifier 108, typically formed of from one to five MOS transistors arranged in various forms of a source follower configuration may be, but need not be, disposed in the wedge like layout areas.

Curved or arc like variants of intermediate registers 110 may provide the same or similar wedge like areas, and are therefore equivalent to non-rectangular parallelogram shaped intermediate registers 110. Charge packets are still transferred down each intermediate register from a first register element to a last register element. A line from the first register element to the last register element defines a first intermediate direction, the first intermediate direction being non-parallel to the column direction.

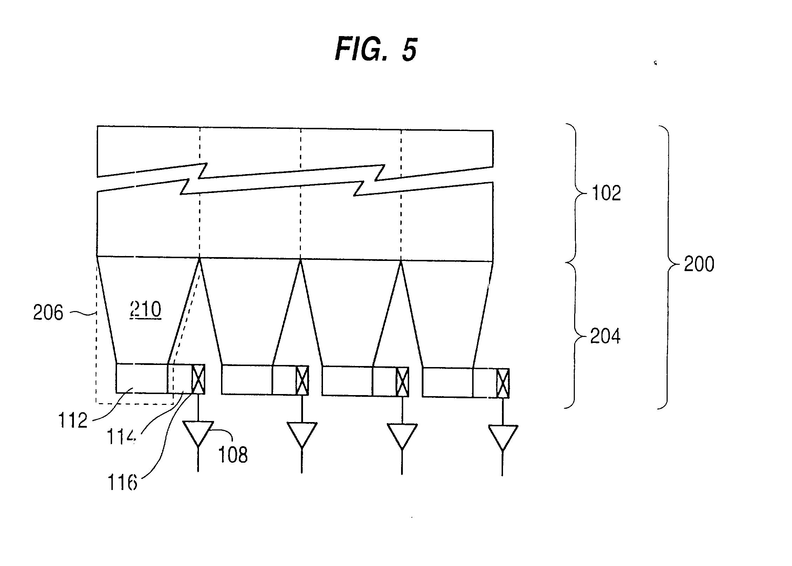

In FIG. 5, sensor 200 includes imaging section 102 (as in FIG. 1) and readout section 204. Readout section 204 includes a plurality of readout subsections 206. Each readout subsection 206 includes a plurality of intermediate registers 210 and a horizontal readout register segment 112. Unlike the readout section shown in FIG. 1, the readout section shown in FIG. 5 includes tapered registers 210 as the intermediate registers. Plural readout subsections 206 (formed oftapered registers 210 and horizontal readout register 112 with reduced horizontal pitch) define wedge shaped layout areas between adjacent readout subsections. Isolation register 114 and output node structure 116 (that is coupled to output buffer amplifier 108) are disposed in a wedge shaped layout area Preferably, horizontal readout register 112, isolation register 114 and output node structure 116 are collinear. Preferably, all horizontal readout registers 112, isolation registers 114 and output node structures 116 in all readout subsections are collinear and perpendicular the a column direction defined by the imaging section.

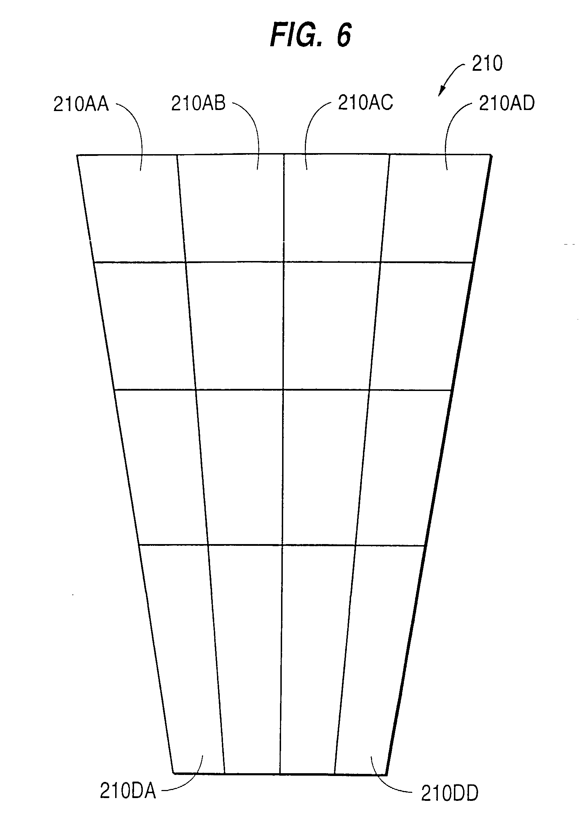

In FIG. 6, a plurality of tapered registers is depicted, each register having a plurality of tapered registered elements. Although FIGS. 5 and 6 depict symmetrically tapered intermediate registers, asymmetrically tapered registers are contemplated as well. For example, first intermediate register includes register elements 210AA through 210DA. Each register element in the first intermediate register is of a trapezoid shape having two parallel but unequal sides. Thus, the shape of the tapered register (i.e., the intermediate registers) varies from one register element to another. Preferably, the areas that characterizes individual register elements remain approximately equal so as to have equal charge capacity.

FIG. 6 shows that the dimension across the top of the intermediate registers (i.e., the interface between the intermediate registers and the imaging subsection) is greater than the dimension across the bottom of the intermediate registers (i.e., the interface between the intermediate registers and the horizontal readout segment register). As depicted in FIG. 5, this arrangement provides a wedge shaped layout area between readout subsections, each readout subsection including the plurality of intermediate registers 210 and horizontal readout register segment 112. In this wedge shaped layout area is disposed isolation registers 114 and output node structure 116. It will be appreciated that a channel width across the shift register formed from readout register 112, isolation register 114 and output node structure 116, may be adjusted wide enough (i.e., in a direction perpendicular to a charge transfer direction) so that the approximate area of each register element equals the approximate area ofthe register elements in the intermediate registers (FIG. 6)so that individual elements of registers 112 and 114 will have equal or greater charge capacity compared to register elements of registers 210.

Curved or arc like variants of intermediate registers 210 may provide the same or similar wedge like areas, and are therefore equivalent to taper shaped intermediate registers 210. Charge packets are still transferred down each intermediate register from a first register element to a last register element. A line from the first register element to the last register element defines a first intermediate direction, the first intermediate direction being non-parallel to the column direction.

Register architectures other than the one specifically depicted in FIG. 1 (with "skirted" intermediate registers) or FIG. 5 (with tapered intermediate registers) are contemplated. The object is to provide a layout area between horizontal register segments sufficient to provide a couple of isolation register elements and an output node structure. For example, in a frame transfer sensor, the storage array includes many register elements in each vertical storage column. Some or all of the register elements in vertical storage columns may be flared (i.e., skirted) or tapered, the remaining elements being vertical and parallel with the column direction. For example, in a frame transfer sensor with a 256 by 256 storage section, only the final 64 register elements in the vertical storage columns may be flared or tapered, the balance being essentially an extension of the vertical register columns in the imaging section. The same applies to frame-interline transfer sensors.

Furthermore, it may be the first 64 register elements of the vertical storage columns that are flared or tapered, first being the first to receive charge from the imaging section. When an isolation section is disposed between the imaging section and the storage section, it may be that the isolation registers in the isolation section, together with none, some or all of the register elements in the vertical storage columns, are flared or tapered. When an isolation section is disposed between the storage section and the readout section, it may be that the isolation registers in the isolation section, together with none, some or all of the register elements in the vertical storage columns, are flared or tapered. In an interline-transfer sensor (i.e., where the vertical storage columns are disposed between columns of photo sites), when an isolation section is disposed between the vertical storage columns and the horizontal readout section, it may be that the isolation registers in the isolation section, together with intermediate registers 110 or 210 are flared or tapered, respectively. In a TDI CCD sensor with vertical columns of photo sites, when an isolation section is disposed between the vertical columns of photo sites and the horizontal readout section, it may be that the isolation registers in the isolation section, together with intermediate registers 110 or 210 are flared or tapered, respectively. Persons skilled in the art will appreciate that combinations of these techniques and other variants are equivalent to the embodiments disclosed herein to provide a layout area between horizontal register segments sufficient to provide a couple of isolation register elements and an output node structure.

Having described preferred embodiments of novel CCD readout sections of a CCD imaging device (which are intended to be illustrative and not limiting), it is noted that modifications and variations can be made by persons skilled in the art in light ofthe above teachings. It is therefore to be understood that changes may be made in the particular embodiments of the invention disclosed which are within the scope and spirit of the invention as defined by the appended claims.

Having thus described the invention with the details and particularity required by the patent laws, what is claimed and desired protected by Letters Patent is set forth in the appended claims.

## Claims

1. In a charge coupled device having an imaging section that defines a column direction and includes a plurality of imaging subsections, a readout section comprising a first output node structure and a plurality of readout subsections, wherein:
a first readout subsection is coupled to a respective first imaging subsection and includes a first plurality of intermediate registers and a first horizontal register segment, a first intermediate register of the first plurality of intermediate registers defining a first intermediate direction, the first intermediate direction being non-parallel to the column direction;
a second readout subsection is coupled to a respective second imaging subsection and includes a second plurality of intermediate registers and a second horizontal register segment, a layout area being defined between the first and second readout subsections; and
the first output node structure is coupled to the first horizontal register segment and disposed within the layout area.

2. The readout section of claim 1, wherein the first horizontal register segment has a plurality of first horizontal register elements, each first horizontal register element being coupled to a corresponding intermediate register of the first plurality of intermediate registers.

3. The readout section of claim 1, further comprising a first isolation register disposed within the layout area between the first horizontal register segment and the first output node structure.

4. The readout section of claim 3, wherein the first horizontal register segment, the first isolation register and the first output node structure are collinear.

5. The readout section of claim 3, wherein the isolation register includes at least two isolation register elements.

6. The readout section of claim 1, wherein:
the first horizontal register segment defines a first horizontal register segment direction;
the second horizontal register segment defines a second horizontal register segment direction; and
the second horizontal register segment direction is parallel with the first horizontal register segment direction.

7. The readout section of claim 1, wherein:
the first horizontal register segment defines a first horizontal register segment direction that is perpendicular to the column direction; and
the second horizontal register segment defines a second horizontal register segment direction, the second horizontal register segment direction being parallel with the first horizontal register segment direction.

8. The readout section of claim 1, wherein:
a first intermediate register of the second plurality of intermediate registers defines a second intermediate direction;
the second intermediate direction is non-parallel to the first intermediate direction; and
the second intermediate direction is non-parallel to the column direction.

9. The readout section of claim 1, wherein:
the first intermediate register of the first plurality of intermediate registers includes a first plurality of register elements, a first register element of the first plurality of register elements being characterized by a first perimeter; and
the first perimeter characterizing the first register element of the first plurality of register elements is a non-rectangular. parallelogram.

10. The readout section of claim 9, wherein:
a second register element of the first plurality of register elements is characterized by a second perimeter; and
the second perimeter characterizing the second register element of the first plurality of register elements is a non-rectangular parallelogram.

11. The readout section of claim 10, wherein a size and shape of the first perimeter is substantially equal to a size and shape of the second perimeter.

12. The readout section of claim 9, wherein:
a second intermediate register of the first plurality of intermediate registers defines a second intermediate direction; and
the second intermediate direction is co-parallel with the first intermediate direction.

13. The readout section of claim 12, wherein:
the second intermediate register includes a second plurality of register elements, a first register element of the second plurality of register elements being characterized by a second perimeter; and
the second perimeter characterizing the first register element of the second plurality of register elements is a non-rectangular parallelogram.

14. The readout section of claim 13 wherein the first and second perimeters are substantially equal in size and shape.

15. The readout section of claim 1, wherein:
a second intermediate register of the first plurality of intermediate registers defines a second intermediate direction;
the second intermediate direction is non-parallel to the first intermediate direction; and
the second intermediate direction is non-parallel to the column direction.

16. The readout section of claim 1, wherein:
the first intermediate register of the first plurality of intermediate registers includes a first plurality of register elements, a first register element of the first plurality of register elements being characterized by a first perimeter; and
the first perimeter characterizing the first register element of the first plurality of register elements is a trapezoid.

17. The readout section of claim 16, wherein:
a second register element of the first plurality of register elements is characterized by a second perimeter; and
the second perimeter characterizing the second register element of the first plurality of register elements is a trapezoid.

18. The readout section of claim 17, wherein a size and shape of the first perimeter is unequal to a size and shape of the second perimeter.

19. The readout section of claim 17, wherein:
an area ofthe first perimeter is substantially equal to an area of the second perimeter; and
a shape ofthe first perimeter is unequal to a shape of the second perimeter.

20. The readout section of claim 16, wherein:
a second intermediate register of the first plurality of intermediate registers defines a second intermediate direction; and
the second intermediate direction is non-parallel with the first intermediate direction.

21. The readout section of claim 20, wherein:
the second intermediate register includes a second plurality of register elements, a first register element of the second plurality of register elements being characterized by a second perimeter; and
the second perimeter characterizing the first register element of the second plurality of register elements is a trapezoid.

22. The readout section of claim 21 wherein the first and second perimeters are substantially equal in size and shape.

23. A method of forming a readout section for a charge coupled device that has an imaging section, the imaging section defining a column direction and including a plurality of imaging subsections, the readout section including a plurality of readout subsections, a first readout subsection being coupled to a respective first imaging subsection, a second readout subsection being coupled to a respective second imaging subsection, the method comprising steps of:
forming the first readout subsection to include a first plurality of intermediate registers and a first horizontal register segment, a first intermediate register ofthe first plurality of intermediate registers defining a first intermediate direction, the first intermediate direction being non-parallel to the column direction;
forming the second readout subsection to include a second plurality of intermediate registers and a second horizontal register segment, the steps of forming the first and second readout subsections defining a layout area between the first and second readout subsections; and
forming a first output node structure coupled to the first horizontal register segment so that the first output node structure is disposed within the layout area.

24. The method of claim 23, wherein the first horizontal register segment is formed to have a plurality of first horizontal register elements, each first horizontal register element being formed to be coupleable to a corresponding intermediate register of the first plurality of intermediate registers.

25. The method of claim 23, further comprising a step of forming a first isolation register disposed within the layout area between the first horizontal register segment and the first output node structure.

26. The method of claim 25, wherein the first horizontal register segment, the first isolation register and the first output node structure are formed to be collinear.

27. The method of claim 25, wherein the isolation register is formed to include at least two isolation register elements.

28. The method of claim 23, wherein:
the first horizontal register segment defines a first horizontal register segment direction;
the second horizontal register segment defines a second horizontal register segment direction; and
the second horizontal register segment direction is parallel with the first horizontal register segment direction.

29. The method of claim 23, wherein:
the first horizontal register segment defines a first horizontal register segment direction that is perpendicular to the column direction; and
the second horizontal register segment defines a second horizontal register segment direction, the second horizontal register segment direction being parallel with the first horizontal register segment direction.

30. The method of claim 23, wherein:
a first intermediate register of the second plurality of intermediate registers defines a second intermediate direction;
the second intermediate direction is non-parallel to the first intermediate direction; and
the second intermediate direction is non-parallel to the column direction.

31. The method of claim 23, wherein:
the first intermediate register of the first plurality of intermediate registers is formed to include a first plurality of register elements, a first register element of the first plurality of register elements being characterized by a first perimeter; and
the first perimeter characterizing the first register element of the first plurality of register elements is a non-rectangular parallelogram.

32. The method of claim 31, wherein:
a second register element of the first plurality of register elements is characterized by a second perimeter; and
the second perimeter characterizing the second register element of the first plurality of register elements is a non-rectangular parallelogram.

33. The method of claim 32, wherein a size and shape of the first perimeter is substantially equal to a size and shape of the second perimeter.

34. The method of claim 31, wherein:
a second intermediate register of the first plurality of intermediate registers defines a second intermediate direction; and
the second intermediate direction is co-parallel with the first intermediate direction.

35. The method of claim 34, wherein:
the second intermediate register is formed to include a second plurality of register elements, a first register element of the second plurality of register elements being characterized by a second perimeter; and
the second perimeter characterizing the first register element of the second plurality of register elements is a non-rectangular parallelogram.

36. The method of claim 35 wherein the first and second perimeters are substantially equal in size and shape.

37. The method of claim 23, wherein:
a second intermediate register of the first plurality of intermediate registers defines a second intermediate direction;
the second intermediate direction is non-parallel to the first intermediate direction; and
the second intermediate direction is non-parallel to the column direction.

38. The method of claim 23, wherein:
the first intermediate register of the first plurality of intermediate registers is formed to include a first plurality of register elements, a first register element of the first plurality of register elements being characterized by a first perimeter; and
the first perimeter characterizing the first register element of the first plurality of register elements is a trapezoid.

39. The method of claim 38, wherein:
a second register element of the first plurality of register elements is characterized by a second perimeter; and
the second perimeter characterizing the second register element of the first plurality of register elements is a trapezoid.

40. The method of claim 39, wherein a size and shape of the first perimeter is unequal to a size and shape of the second perimeter.

41. The method of claim 39, wherein:
an area of the first perimeter is substantially equal to an area of the second perimeter; and
a shape of the first perimeter is unequal to a shape ofthe second perimeter.

42. The method of claim 38, wherein:
a second intermediate register ofthe first plurality of intermediate registers defines a second intermediate direction; and
the second intermediate direction is non-parallel with the first intermediate direction.

43. The method of claim 42, wherein:
the second intermediate register is formed to include a second plurality of register elements, a first register element of the second plurality of register elements being characterized by a second perimeter; and
the second perimeter characterizing the first register element of the second plurality of register elements is a trapezoid.

44. The method of claim 43 wherein the first and second perimeters are substantially equal in size and shape.

45. A charge coupled device (100) ) comprising an imaging section (102) ) and a readout section ( 104), the imaging section (102) comprising a plurality of imaging subsections, each of which is coupled to a respective readout subsection (106) comprising a readout register (112) spaced from its respective imaging subsection by an intermediate register (110), wherein the intermediate register (110) ) is shaped (eg angled or tapered) ) to provide a region between adjacent readout registers (112) for receiving isolation register elements (114) or output node structures (116).
